# EUROPÄISCHE PATENTSCHRIFT

(11) **EP 3 240 124 B1**
(45) Veröffentlichungstag und Bekanntmachung des Hinweises auf die Patenterteilung: **27.03.2019**
(21) Anmeldenummer: 17163786.1
(22) Anmeldetag: 30.03.2017
(51) Int. Cl.: H01S 3/094, H01S 3/06, H01S 3/04, H01S 3/0941, H01S 3/042, H01S 5/00

(54) **PUMPLICHTANORDNUNG, SCHEIBENLASER DAMIT UND VERFAHREN ZUM PUMPEN EINES LASERAKTIVEN MEDIUMS**
PUMP LIGHT ARRANGEMENT, DISC LASER USING THE SAME AND METHOD FOR PUMPING A LASER-ACTIVE MEDIUM
ENSEMBLE DE LUMIÈRE DE POMPAGE, LASER ASSOCIÉ ET PROCÉDÉ DE POMPAGE D'UN MILIEU LASER

(30) Priorität: 26.04.2016 DE 102016207017
(43) Veröffentlichungstag der Anmeldung: 01.11.2017
(73) Patentinhaber: TRUMPF Laser GmbH, 78713 Schramberg (DE)
(72) Erfinder: Schad, Sven-Silvius, 78628 Rottweil (DE); Herkommer, Alois, 70569 Stuttgart (DE); Ackermann, Matthias, 78628 Rottweil (DE)
(74) Vertreter: Kohler Schmid Möbus Patentanwälte

(56) Entgegenhaltungen:
- DE-A1-102013 114 748
- US-A1- 2006 209 918
- US-A1- 2014 016 662

## Beschreibung

Die vorliegende Erfindung betrifft eine Pumplichtanordnung für einen Scheibenlaser, umfassend: eine Fokussiereinrichtung, insbesondere einen Hohlspiegel, mit einer Reflexionsfläche zur Fokussierung eines Pumplichtstrahls auf ein laseraktives Medium, sowie eine Umlenkanordnung zur Umlenkung des Pumplichtstrahls zwischen an der Reflexionsfläche gebildeten Reflexionsbereichen, die in unterschiedlichen Winkelbereichen um eine Mittelachse der Reflexionsfläche in mindestens einem ersten Ringbereich und einem zweiten Ringbereich angeordnet sind, wobei die Umlenkanordnung ausgebildet ist, mindestens eine Umlenkung des Pumplichtstrahls zwischen zwei Reflexionsbereichen des ersten Ringbereichs und mindestens eine Umlenkung zwischen zwei Reflexionsbereichen des zweiten Ringbereichs vorzunehmen. Die Erfindung betrifft auch einen Scheibenlaser mit einer solchen Pumplichtanordnung sowie ein Verfahren zum Pumpen eines laseraktiven Mediums, umfassend: Mehrmaliges Fokussieren eines Pumplichtstrahls auf das laseraktive Medium mittels einer Fokussiereinrichtung, insbesondere mittels eines Hohlspiegels, wobei zwischen aufeinander folgenden Fokussierungsschritten eine Umlenkung des Pumplichtstrahls zwischen unterschiedlichen Reflexionsbereichen einer Reflexionsfläche der Fokussiereinrichtung erfolgt, die in unterschiedlichen Winkelbereichen um eine Mittelachse der Reflexionsfläche herum in mindestens einem ersten Ringbereich und einem zweiten Ringbereich angeordnet sind, wobei der Pumplichtstrahl sowohl zwischen zwei Reflexionsbereichen des ersten Ringbereichs als auch zwischen zwei Reflexionsbereichen des zweiten Ringbereichs jeweils mindestens einmal umgelenkt wird. Bei dem Winkelbereich, in dem ein jeweiliger Reflexionsbereich gebildet ist, kann es sich beispielsweise um ein Kreissegment der Reflexionsfläche der Fokussiereinrichtung handeln.

Scheibenlaser besitzen ein laseraktives Medium (Verstärkermedium) mit geringer Dicke (Laserscheibe), welches gut gekühlt werden kann. Dadurch eignet sich das Konzept des Scheibenlasers für hohe Laserleistungen im Multi-Kilowatt-Bereich. Wegen der geringen Dicke des Verstärkermediums wird allerdings bei einem Durchgang durch das laseraktive Medium wenig Pumplicht absorbiert, was ohne das Vorsehen geeigneter Maßnahmen beim Pumpen des laseraktiven Mediums eine geringe Effizienz des Lasersystems zur Folge hat. Um eine für die Erfüllung der Laserbedingung in dem laseraktiven Medium benötigte Mindestenergie bzw. Mindest-Laserleistung zu erhalten, wird in der Regel ein Mehrfachdurchgang der Pumpstrahlung durch das laseraktive Medium benötigt. Bei einem solchen Mehrfachdurchgang wird der Pumplichtstrahl mehrfach auf das laseraktive Medium fokussiert, wobei bei aufeinander folgenden Fokussierungsschritten idealer Weise eine 1:1 Abbildung des Pumpflecks erzeugt wird. Die wiederholte Abbildung über den Hohlspiegel führt zu einer Verschlechterung der Kollimation im parallelen Strahlengang, so dass der kollimierte Strahldurchmesser zunimmt und die in das laseraktive Medium eingekoppelte Leistung abnimmt, was die Zahl der Mehrfachdurchgänge limitiert.

In der EP 1 252 687 B1 sowie in der Dissertation "Pumpoptiken und Resonatoren für Scheibenlaser", S. Erhard, Universität Stuttgart, 2002, ISBN 3-8316-0173-9 ist eine Pumpanordnung beschrieben, bei welcher der Pumplichtstrahl mit Hilfe eines Parabolspiegels auf das laseraktive Medium fokussiert wird. Der Mehrfachdurchgang wird dadurch erreicht, dass der Pumplichtstrahl mehrmals mit Hilfe von Umlenkeinrichtungen, z.B. Prismen, zwischen unterschiedlichen Reflexionsbereichen umgelenkt wird, die in unterschiedlichen Kreissektoren in ein- und demselben Ringbereich des Parabolspiegels liegen.

In der Dissertation "Scheibenlaser mit Kilowatt-Dauerstrichleistung", C. Stewen, Universität Stuttgart, 2002, ISBN 3-89675-763, wird vorgeschlagen, unter Verwendung mehrerer Umlenkeinheiten mehrere Ringbereiche mit Reflexionsbereichen auf dem Parabolspiegel zur Abbildung zu nutzen, wobei die einzelnen Ringe radial in einem Segment des Parabolspiegels angeordnet sind.

Eine ähnliche Pumpanordnung ist aus der DE 10 2011 004 204 A1 bekannt geworden. Bei der dort beschriebenen Pumplichtanordnung kann die Reflexionsfläche zwei, drei oder mehr Ringbereiche mit einer Mehrzahl von Reflexionsbereichen aufweisen. Eine Umlenkung des Pumplichtstrahls innerhalb eines jeweiligen Ringbereichs erfolgt in azimutaler Richtung, eine Umlenkung zwischen Reflexionsbereichen unterschiedlicher Ringbereiche in radialer Richtung.

Je größer der Abstand der Reflexionsbereiche von der Mittelachse der Reflexionsfläche ist, desto größer sind typischer Weise die Abbildungsfehler. Insbesondere für den Fall, dass drei oder mehr Ringbereiche verwendet werden, um den Pumplichtstrahl umzulenken bzw. auf das laseraktive Medium zu fokussieren, weist zumindest der radial äußerste Ringbereich typischer Weise einen Abstand von der Mittelachse der Reflexionsfläche auf, der so groß ist, dass die Abbildungsfehler stark zunehmen, so dass es zu einer merklichen Aufweitung des Pumplichtstrahls kommt, die ggf. zu so genannten Clipping-Effekten (Abschneideverlusten) an Umlenkeinrichtungen beispielsweise in Form von Prismen führen kann.

Wird eine Pumplichtquelle mit einer hohen Strahlqualität verwendet, ist der Strahldurchmesser, mit dem der Pumplichtstrahl von der Pumplichtquelle kommend auf die Reflexionsfläche trifft, vergleichswiese klein. Daher kann die Ausdehnung der Reflexionsfläche in radialer Richtung realisiert werden, wodurch die Problematik der Strahlaufweitung reduziert bzw. minimiert wird. Pumplichtquellen mit hoher Strahlqualität, beispielsweise Diodenlaser, sind jedoch teuer. Insbesondere bei hohen Pumpleistungen sollten jedoch möglichst kostengünstige Pumplichtquellen verwendet werden, bei denen typischer Weise die oben genannten Effekte auftreten.

### Aufgabe der Erfindung

Der Erfindung liegt die Aufgabe zugrunde, eine Pumplichtanordnung, einen Scheibenlaser mit einer solchen Pumplichtanordnung sowie ein zugehöriges Verfahren zum Pumpen eines laseraktiven Mediums bereitzustellen, welche eine Kompensation von Abbildungsfehlern bei der mehrfachen Fokussierung des Pumplichtstrahls auf das laseraktive Medium ermöglichen.

### Gegenstand der Erfindung

Diese Aufgabe wird erfindungsgemäß gelöst durch eine Pumplichtanordnung der eingangs genannten Art, bei der die Umlenkeinrichtung ausgebildet ist, eine Anzahl von Umlenkungen zwischen zwei Reflexionsbereichen der beiden Ringbereiche mit einer Bildumkehr des Pumplichtstrahls in radialer Richtung zur Mittelachse vorzunehmen, die mindestens einem Drittel, bevorzugt mindestens der Hälfte der Gesamtzahl von Umlenkungen zwischen zwei Reflexionsbereichen der beiden Ringbereiche entspricht.

Bei der hier beschriebenen Pumplichtanordnung trifft der von einer Pumplichtquelle ausgehende Pumplichtstrahl typischer Weise kollimiert und in der Regel mit elliptischem Strahlquerschnitt parallel zur Mittelachse auf die z.B. asphärisch, insbesondre als Paraboloid ausgebildete Reflexionsfläche auf, wobei der Pumplichtstrahl mit dem elliptischen Strahlquerschnitt durch die Reflexionsfläche typischer Weise rund auf dem laseraktiven Medium abgebildet wird. Die Reflexionsbereiche sind in einer Projektion auf eine Ebene senkrecht zur Mittelachse in der Regel kreisförmig ausgebildet. Ist im Folgenden von kreisförmigen Reflexionsbereichen die Rede, bezieht sich dies jeweils auf die Projektion in eine Ebene senkrecht zur Mittelachse.

Bei der Umlenkung zwischen zwei Reflexionsbereichen mit Hilfe der Umlenkanordnung ist der Pumplichtstrahl in der Regel kollimiert. Zwischen einer ersten Umlenkung mittels der Umlenkanordnung und einer zeitlich nachfolgenden zweiten Umlenkung mittels der Umlenkanordnung wird der Pumplichtstrahl von der Fokussiereinrichtung auf das laseraktive Medium fokussiert und nach dem Durchlaufen des laseraktiven Mediums erneut kollimiert. Das laseraktive Medium ist typischer Weise als Laserscheibe ausgebildet, die in einer Brennebene bzw. im Brennpunkt bzw. der Brennebene der Fokussiereinrichtung, beispielsweise in Form eines Parabolspiegels, angeordnet ist. Die Brennweite eines solchen Parabolspiegels weist jedoch eine quadratische Abhängigkeit vom Einfallswinkel auf und ist daher nur für kleine Einfallswinkel des auftreffenden Pumplichtstrahls näherungsweise konstant. Je größer der Abstand des auf die Reflexionsfläche auftreffenden Pumplichtstrahls von der Mittelachse ist, desto größer ist der Einfallswinkel und desto stärker ist die Änderung der Brennweite. Der in der Pumplichtanordnung verwendete Pumplichtstrahl weist einen Strahlquerschnitt auf, der in radialer Richtung so groß ist, dass die Unterschiede zwischen den Einfallswinkeln der radial innen und außen liegenden Randstrahlen des Pumplichtstrahls insbesondere bei Reflexionsbereichen, die einen großen Abstand von der Mittelachse aufweisen, nicht vernachlässigt werden können und zu einem Abbildungsfehler führen. Dieser Abbildungsfehler tritt jedes Mal auf, wenn der Pumplichtstrahl zwischen zwei aufeinander folgenden Umlenkungen auf das laseraktive Medium fokussiert wird. Die Abbildungsfehler bei der mehrmaligen Fokussierung auf das laseraktive Medium addieren sich auf und führen zu einer Aufweitung des Pumplichtstrahls und ggf. zu den weiter oben beschriebenen Abschneide-Effekten an den Umlenkeinrichtungen, sofern diese vom Pumplichtstrahl überstrahlt werden.

Aufgrund des Abbildungsfehlers lässt sich eine ideale telezentrische Abbildung nur für genau ein Strahlenbündel des Pumplichtstrahls erreichen, bei dem es sich typischer Weise um das mittlere Feld, d.h. um das in der Mitte des Strahlquerschnitts verlaufende Strahlenbündel des Pumplichtstrahls handelt, wenn der Abstand zwischen einer jeweiligen Umlenkeinrichtung der Umlenkanordnung und der Reflexionsfläche geeignet gewählt wird. Der Strahlengang an den radial außen und innen liegenden Rändern des Pumplichtstrahls lässt sich durch die Veränderung des Abstands zwischen Umlenkeinrichtung und Reflexionsfläche jedoch nicht korrigieren, so dass die in radialer Richtung vom Zentrum des Strahlquerschnitt des Pumplichtstrahls abweichenden Strahlenbündel, insbesondere die Randstrahlen, einen instabilen Strahlengang aufweisen, der zu der weiter oben beschriebenen Aufweitung des Pumplichtstrahls führt.

Die Erfinder haben erkannt, dass dieser Abbildungsfehler durch eine Bildumkehr des Pumplichtstrahls in radialer Richtung bei der Umlenkung mit der Umlenkeinrichtung kompensiert werden kann: Bei der Bildumkehr wird der Strahlquerschnitt des Pumplichtstrahls in radialer Richtung gespiegelt, so dass radial innen und radial außen liegende Strahlenbündel des Pumplichtstrahls vertauscht werden. Die Wirkung der unterschiedlichen Brennweite der Reflexionsfläche auf die in unterschiedlichem radialem Abstand zur Mittelachse auftreffenden Strahlenbündel des Pumplichtstrahls wird daher bei einer nachfolgenden Fokussierung umgekehrt, so dass der Abbildungsfehler kompensiert werden kann, der bei einer vorausgehenden Fokussierung entstanden ist.

Typischer Weise ist es für eine optimale Kompensation günstig, wenn die Anzahl der Umlenkungen mit der radialen Bildumkehr mindestens der Hälfte der Gesamtzahl der Umlenkungen zwischen jeweils zwei der Reflexionsflächen der beiden Ringbereiche entspricht, es kann jedoch ggf. auch eine geringere Anzahl von Umlenkungen mit radialer Bildumkehr erfolgen, beispielsweise mehr als ein Drittel der Umlenkungen mit radialer Bildumkehr, um eine teilweise Kompensation der Abbildungsfehler zu erreichen. Unter der Hälfte bzw. dem Drittel der Gesamtzahl der Umlenkungen wird bei einer ungeraden bzw. nicht durch Drei teilbaren Gesamtzahl der Umlenkungen die auf den nächst kleineren ganzzahligen Wert abgerundete Anzahl von Umlenkungen verstanden.

Bei einer Ausführungsform ist die Umlenkanordnung ausgebildet, für eine Bildumkehr des Pumplichtstrahls in radialer Richtung zur Mittelachse eine Umlenkung des Pumplichtstrahls von einem Reflexionsbereich des ersten Ringbereichs auf einen Reflexionsbereich des zweiten Ringbereichs oder umgekehrt vorzunehmen. Die Umlenkung zwischen zwei Reflexionsbereichen, die an zwei unterschiedlichen Ringbereichen gebildet sind, erfolgt typischer Weise in Form einer 180°-Umlenkung, beispielsweise mit Hilfe von Umlenkeinrichtungen in Form von Prismen oder ggf. in Form von Faserbündeln. Bei einer solchen 180°-Umlenkung erfolgt typischer Weise automatisch eine Bildumkehr des Strahlquerschnitts des Pumplichtstrahls (im Wesentlichen) in radialer Richtung. Auch bei der 180°-Umlenkung zwischen zwei Reflexionsbereichen in ein- und demselben Ringbereich erfolgt typischer Weise eine Bildumkehr, allerdings (im Wesentlichen) in azimutaler Richtung. Eine azimutale Umlenkung zwischen zwei Reflexionsbereichen des ersten Ringbereichs oder zwischen zwei Reflexionsbereichen des zweiten Ringbereichs erzeugt keine radiale Bildumkehr und trägt daher nicht zu einer Kompensation der weiter oben beschriebenen Abbildungsfehler bei.

Bei einer vorteilhaften Ausführungsform ist die Umlenkanordnung ausgebildet, zwischen jeder Umlenkung des Pumplichtstrahls zwischen zwei Reflexionsbereichen des ersten Ringbereichs und jeder Umlenkung des Pumplichtstrahls zwischen zwei Reflexionsbereichen des zweiten Ringbereichs (genau) eine Umlenkung des Pumplichtstrahls von einem Reflexionsbereich des ersten Ringbereichs auf einen Reflexionsbereich des zweiten Ringbereichs oder umgekehrt vorzunehmen.

Für die Kompensation der weiter oben beschriebenen Abbildungsfehler ist es vorteilhaft, wenn die Umlenkungen des Pumplichtstrahls in zwei typischer Weise benachbarten Ringbereichen, die insbesondere die beiden in radialer Richtung äußersten Ringbereiche der Reflexionsfläche bilden, immer im Wechsel zwischen einer Umlenkung in radialer Richtung und einer Umlenkung in azimutaler Richtung erfolgen, da hierdurch bei zwei unmittelbar aufeinander folgenden Fokussierungen des Pumplichtstrahls auftretende Abbildungsfehler gegenseitig kompensiert werden. Typischer Weise ist die Umlenkanordnung ausgebildet, zumindest zwei Umlenkungen in radialer Richtung vorzunehmen, d.h. den Pumplichtstrahl sowohl mindestens einmal von einem Reflexionsbereich des ersten Ringbereichs auf einen Reflexionsbereich des zweiten Ringbereichs umzulenken als auch mindestens einmal in umgekehrter Richtung, d.h. von einem Reflexionsbereich des zweiten Ringbereichs auf einen Reflexionsbereich des ersten Ringbereichs. Der Pumplichtstrahl wird zumindest in einem der beiden Ringbereiche, in der Regel in beiden Ringbereichen, mindestens zwei Mal in azimutaler Richtung umgelenkt.

Bei einer Ausführungsform ist die Umlenkanordnung ausgebildet, eine Anzahl von Umlenkungen des Pumplichtstrahls von einem Reflexionsbereich des ersten Ringbereichs auf einen Reflexionsbereich des zweiten Ringbereichs oder umgekehrt vorzunehmen, die von der Anzahl von Umlenkungen zwischen zwei Reflexionsbereichen des ersten Ringbereichs und zwischen zwei Reflexionsbereichen des zweiten Ringbereichs um nicht mehr als Eins abweicht.

Für eine optimale Kompensation wird die Anzahl der Umlenkungen in radialer Richtung, d.h. zwischen den beiden Ringbereichen, idealer Weise gleich groß gewählt wie die Anzahl der Umlenkungen in azimutaler Richtung, d.h. der Summe aus den Umlenkungen zwischen den Reflexionsbereichen des ersten Ringbereichs und den Umlenkungen zwischen den Reflexionsbereichen des zweiten Ringbereichs. Mit anderen Worten wird die Gesamtzahl der Umlenkungen zu gleichen Teilen in radiale und azimutale Umlenkungen aufgeteilt. Eine solche Aufteilung ist nur möglich, wenn es sich bei der Gesamtzahl der Umlenkungen um eine gerade Zahl handelt. Handelt es sich bei der Gesamtzahl der Umlenkungen um eine ungerade Zahl, wird zur möglichst gleichmäßigen Aufteilung der Gesamtzahl der Umlenkungen auf radiale und azimutale Umlenkungen typischer Weise die Anzahl der radialen Umlenkungen um Eins größer gewählt als die Anzahl der azimutalen Umlenkungen, oder umgekehrt. Auf diese Weise wird der weiter oben beschriebene Abbildungsfehler auch bei großen Abständen der Reflexionsbereiche von der Mittelachse praktisch vollständig kompensiert.

Bei einer weiteren Ausführungsform weist die Umlenkanordnung mindestens eine Umlenkeinrichtung zur Umlenkung des Pumplichtstrahls zwischen jeweils zwei Reflexionsbereichen der Reflexionsfläche auf, die zwei insbesondere spiegelsymmetrisch zu einer Symmetrieebene ausgerichtete Umlenkflächen umfasst. Die beiden Umlenkflächen sind typischer Weise unter einem Winkel von 90° zueinander ausgerichtet und bewirken jeweils eine Umlenkung des Pumplichtstrahls um 90°, um die 180°-Umlenkung zu erzeugen. Sofern eine der beiden Umlenkflächen in einer Richtung senkrecht zur Einfallsebene einen veränderlichen Abstand zur Symmetrieebene aufweist, ist typischer Weise zumindest der in der Einfallsebene des Pumplichtstrahls liegende Flächenabschnitt dieser Umlenkfläche spiegelsymmetrisch zur Symmetrieebene angeordnet.

Die oben beschriebene Umlenkeinrichtung erzeugt eine Bildumkehr des Pumplichtstrahls bezüglich der Symmetrieebene. Ist die Symmetrieebene im Wesentlichen in azimutaler Richtung ausgerichtet, wie dies in der Regel bei der radialen Umlenkung zwischen zwei Reflexionsbereichen aus unterschiedlichen Ringbereichen der Fall ist, erfolgt bei einer derart ausgebildeten Umlenkeinrichtung automatisch eine Bildumkehr in radialer Richtung.

Bei einer Weiterbildung ist mindestens eine Umlenkeinrichtung zur zusätzlichen Bildumkehr des Pumplichtstrahls bezüglich einer Einfallsebene des Pumplichtstrahls, d.h. typischer Weise senkrecht zur Symmetrieebene, ausgebildet. Durch die zusätzliche Bildumkehr kann auch eine Umlenkeinrichtung, die zur Umlenkung in azimutaler Richtung, d.h. zwischen zwei Reflexionsbereichen ein- und desselben Ringbereichs verwendet wird, eine radiale Bildumkehr erzeugen. Es ist somit nicht zwingend erforderlich, für die radiale Bildumkehr eine Umlenkung in radialer Richtung vorzunehmen. Zur Kompensation von Abbildungsfehlern kann in diesem Fall beispielsweise wie bei herkömmlichen Pumplichtanordnungen eine Umlenkung in einem jeweiligen Ringbereich ausschließlich (mit Ausnahme der Ein- bzw. der Auskopplung des Pumplichtstrahls) in azimutaler Richtung erfolgen. Insbesondere kann in diesem Fall mehr als der Hälfte der Umlenkungen, insbesondere jede Umlenkung in azimutaler Richtung mit einer Bildumkehr in radialer Richtung zur Mittelachse erfolgen.

Die Umlenkflächen sind bevorzugt an einem oder an mehreren Prismen gebildet. Die Umlenkeinrichtung kann beispielsweise als 180°-Umlenkprisma unter Ausnutzung von Totalreflexion an den als Umlenkflächen dienenden Kathetenflächen ausgebildet sein. Es ist aber auch möglich, z.B. zwei Prismen (oder ein Biprisma) mit jeweils einer verspiegelten Hypotenusenfläche als Umlenkfläche als 180°-Umlenkeinrichtung mit Strahlversatz zu verwenden. Alternativ können z.B. auch zwei Planspiegel zur Umlenkung verwendet werden, deren reflektierende Umlenkflächen unter einem Winkel von 90° zueinander ausgerichtet sind und die sich ggf. an einer gemeinsamen Kante berühren.

Bei einer Weiterbildung ist eine der beiden Umlenkflächen zur zusätzlichen Bildumkehr des Pumplichtstrahls bezüglich einer Einfallsebene des Pumplichtstrahls an einem Dachkantprisma gebildet. Ein Dachkantprisma (nach Amici) ermöglicht in Kombination mit der anderen Umlenkfläche, die beispielsweise an einem herkömmlichen Prisma oder einem Spiegel gebildet sein kann, eine vollständige Bildumkehr des Pumplichtstrahls bei der 180°-Umlenkung. Wie weiter oben beschrieben wurde, kann durch eine solche vollständige Bildumkehr auch bei einer Umlenkeinrichtung, die zur Umlenkung zwischen (insbesondere benachbarten) Reflexionsbereichen ein- und desselben Ringbereichs dient, eine Bildumkehr in radialer Richtung erzeugt werden. Die Dachkante des Dachkantprismas ist in diesem Fall typischer Weise in der Einfalls- (und Ausfalls)ebene des Pumplichtstrahls angeordnet.

An Stelle von Umlenkeinrichtungen mit insbesondere zueinander senkrechten Umlenkflächen können ggf. auch andere Arten von Umlenkeinrichtungen, z.B. Faserbündel, als Umlenkeinrichtungen eingesetzt werden. Auch muss nicht zwingend wie oben beschrieben eine 180°-Umlenkung des Pumplichtstrahls vorgenommen werden. Grundsätzlich ist aber eine Umlenkeinrichtung günstig, die lediglich eine Umkehr der Propagationsrichtung des Pumplichtstrahls zusammen mit einem Strahlversatz erzeugt, d.h. eine Umlenkung, welche die Propagationsrichtung des Pumplichtstrahls umkehrt und diesen parallel verschiebt, sowie bei der Umlenkung die weiter oben beschriebene Spiegelung des Strahlprofils des Pumplichtstrahls, d.h. eine Bildumkehr in einer Richtung, oder ggf. eine vollständige Bildumkehr vornimmt.

Bei einer Ausführungsform ist die Umlenkanordnung ausgebildet, die Umlenkung des Pumplichtstrahls zwischen jeweils zwei azimutal benachbarten Reflexionsbereichen des ersten Ringbereichs und zwischen jeweils zwei azimutal benachbarten Reflexionsbereichen des zweiten Ringbereichs vorzunehmen. Es hat sich für die Minimierung von Abbildungsfehlern als günstig erwiesen, wenn die Umlenkung in azimutaler Richtung zwischen unmittelbar benachbarten Reflexionsbereichen erfolgt. Es versteht sich aber, dass eine azimutale Umlenkung zwischen nicht benachbarten Reflexionsbereichen des ersten oder des zweiten Ringbereichs ebenfalls möglich ist.

Bei einer weiteren Ausführungsform ist die Umlenkanordnung ausgebildet, die Umlenkung des Pumplichtstrahls zwischen jeweils zwei radial benachbarten Reflexionsbereichen des ersten Ringbereichs und des zweiten Ringbereichs vorzunehmen. Eine Umlenkung des Pumplichtstrahls zwischen zwei in radialer Richtung benachbarten Reflexionsbereichen eines jeweiligen Ringbereichs hat sich im Hinblick auf die Reduzierung von Abbildungsfehlern ebenfalls als günstig erwiesen.

Bei einer weiteren Ausführungsform ist die Anzahl der Reflexionsbereiche des ersten Ringbereichs und des zweiten Ringbereichs gleich groß. Für eine gleichmäßige Aufteilung der Gesamtzahl von Umlenkungen ist es günstig, wenn beide Ringbereiche eine identische Anzahl von Reflexionsbereichen aufweisen. Bei den beiden Ringbereichen wird typischer Weise jeweils ein Reflexionsbereich benötigt, um den Pumplichtstahl in einen der beiden Ringbereiche einzukoppeln, sowie ein Reflexionsbereich, um den Pumplichtstrahl aus dem anderen der beiden Ringbereiche auszukoppeln, beispielsweise um den Pumplichtstrahl an einem Retroreflektor bzw. Endspiegel in sich zurück zu reflektieren oder diesen zu einem weiteren Ringbereich umzulenken. Die Anzahl der Reflexionsbereiche, die bei einem jeweiligen Ringbereich für die azimutale und die radiale Umlenkung zur Verfügung steht, ist daher typischer Weise um Eins kleiner als die Gesamtzahl der Reflexionsbereiche eines jeweiligen Ringbereichs.

Bei einer Weiterbildung dieser Ausführungsform weisen sowohl der erste als auch der zweite Ringbereich eine Anzahl von vierzehn Reflexionsbereichen auf. Es hat sich gezeigt, dass eine solche Anzahl von Reflexionsbereichen der Reflexionsfläche einerseits hinsichtlich der Abbildungsfehler und andererseits hinsichtlich des Bauraums, der für die Umlenkeinrichtungen benötigt wird, vorteilhaft ist.

Bei einer weiteren Ausführungsform umfasst die Reflexionsfläche mindestens einen dritten, radial innen liegenden Ringbereich, der von dem ersten und dem zweiten Ringbereich der Reflexionsfläche (ringförmig) umgeben ist. Wie weiter oben beschrieben wurde, ist eine gleichmäßige Aufteilung der Umlenkungen auf radiale und azimutale Umlenkungen insbesondere bei Ringbereichen günstig, die weit von der Mittelachse der Reflexionsfläche entfernt sind. Bei dem dritten und ggf. weiteren radial innen liegenden Ringbereichen ist eine solche gleichmäßige Aufteilung nicht zwingend erforderlich, kann aber ebenfalls vorgenommen werden, wenn mindestens zwei radial innen liegende Ringbereiche vorhanden sind. Ist nur ein einziger radial innen liegender Ringbereich vorhanden, erfolgt typischer Weise eine rein azimutale Umlenkung zwischen den Reflexionsbereichen dieses Ringbereichs, wie dies beispielsweise in der weiter oben zitierten DE 10 2011 004 204 A1 der Fall ist.

Wie weiter oben beschrieben wurde, kann die Anzahl der Durchgänge durch das laseraktive Medium verdoppelt werden, wenn der Pumplichtstrahl an einer Umlenkeinheit in Form eines Retroreflektors, beispielsweise eines planen Endspiegels, in sich zurück reflektiert wird. Beispielsweise kann bei einer Anzahl von 36 Reflexionsbereichen durch die Verwendung eines Retroreflektors eine Anzahl von 72 Durchläufen durch das laseraktive Medium realisiert werden.

Bei einer Weiterbildung weist der dritte, innere Ringbereich eine Anzahl von acht Reflexionsbereichen auf. Die Anzahl der Reflexionsbereiche des inneren Ringbereichs ist auf die Anzahl der Reflexionsbereiche der beiden äußeren Ringbereiche abgestimmt, wobei der für die Umlenkeinrichtungen benötigte Bauraum berücksichtigt wird. Die Verwendung von acht Reflexionsbereichen hat sich als besonders vorteilhaft herausgestellt.

Bei einer weiteren Weiterbildung ist die Umlenkanordnung ausgebildet, den Pumplichtstrahl mindestens zwei Mal unmittelbar aufeinander folgend zwischen jeweils zwei Reflexionsbereichen des dritten Ringbereichs umzulenken. Wie weiter oben beschrieben wurde, erfolgt bei dem dritten Ringbereich typischer Weise eine azimutale Umlenkung des Pumplichtstrahls, d.h. es erfolgt in der Regel nicht zwischen jeweils zwei azimutalen Umlenkungen eine Umlenkung in radialer Richtung, beispielsweise zu einem ggf. vorhandenen vierten, weiter radial innen liegenden Ringbereich. Eine solche Umlenkung im Wesentlichen in azimutaler Richtung ist insbesondere bei der Verwendung von Umlenkprismen als Umlenkeinrichtungen günstig, da es bei einer Umlenkung, bei welcher der kollimierte Pumplichtstrahl durch das Zentrum der Pumpanordnung propagiert, in der Regel zu Abschneideverlusten durch den inneren Prismensatz der Umlenkanordnung kommt.

Es hat sich ebenfalls als günstig erwiesen, wenn die Umlenkanordnung zur Umlenkung des Pumplichtstrahls zwischen jeweils zwei der Reflexionsbereiche in radialer oder in azimutaler Richtung jeweils eine eigene Umlenkeinrichtung, d.h. eine eigene Baueinheit, aufweist. Es versteht sich aber, dass ein- und dieselbe Umlenkeinrichtung ggf. auch zur Umlenkung des Pumplichtstrahls zwischen mehreren Reflexionsbereichen ausgebildet sein kann, wie dies beispielsweise in der eingangs zitierten DE 10 2011 004 204 A1 beschrieben ist, die in ihrer Gesamtheit durch Bezugnahme zum Inhalt dieser Anmeldung gemacht wird.

Bei einer weiteren Ausführungsform weist die Reflexionsfläche eine asphärische Form, insbesondere eine Parabelform, auf. Die Reflexionsfläche kann insbesondere eine asphärische Form aufweisen, die geringfügig von einer Parabelform abweicht. Als Fokussiereinrichtung dient in der Regel ein Hohlspiegel, der typischer Weise eine (annähernd) parabolische Reflexionsfläche aufweist, um zu erreichen, dass der vom laseraktiven Medium kommende Pumplichtstrahl an der (rotationssymmetrischen) Reflexionsfläche kollimiert wird. Diese Funktion kann ggf. auch von anderen asphärischen Flächen erfüllt werden oder es kann ggf. eine Segmentbildung bzw. Facettierung des Hohlspiegels vorgenommen werden, wobei jede der Facetten typischer Weise jeweils einem der Reflexionsbereiche zugeordnet ist.

Bei einer weiteren Ausführungsform umfasst die Pumplichtanordnung zusätzlich eine Pumplichtquelle zur Erzeugung des Pumplichtstrahls. Die Pumplichtquelle erzeugt hierbei Pumplicht, welches an einer Strahlaustrittsfläche austritt, deren Durchmesser den minimalen Durchmesser des Pumplichtstrahls festlegt. Die Pumplichtquelle definiert auch die Divergenz (bzw. den Öffnungswinkel) des Pumplichtstrahls und legt damit das Strahlparameterprodukt des Pumplichtstrahls fest.

Bei einer weiteren Ausführungsform umfasst die Pumplichtanordnung zusätzlich eine im Strahlengang zwischen der Pumplichtquelle und der Reflexionsfläche angeordnete Kollimationsoptik zur Kollimation des Pumplichtstrahls. Der kollimierte Pumplichtstrahl trifft auf die Reflexionsfläche und erzeugt dort einen in der Regel kreisförmigen Reflexionsbereich (engl. "spot"). Wie weiter oben beschrieben wurde, ist das Einstrahlen eines kollimierten Pumplichtstrahls auf die Reflexionsfläche günstig, da dieser nach der Fokussierung auf das laseraktive Medium von diesem zur Reflexionsfläche zurück reflektiert wird und von der (parabelförmigen) Reflexionsfläche erneut kollimiert wird, so dass bei der Umlenkung der Strahldurchmesser im Idealfall nicht vergrößert wird. Zur Erhöhung der Zahl der Durchgänge kann ggf. an Stelle einer Kollimationsoptik auch eine Einkopplungsoptik verwendet werden, wie sie in der DE 10 2013 114 748 A1 beschrieben ist und welche zur Erzeugung eines Einkopplungsfokus bei der Einkopplung des Pumplichtstrahls von der Pumplichtquelle in Richtung auf die Reflexionsfläche ausgebildet ist. Wie dies ebenfalls in der DE 10 2013 114 748 A1 beschrieben ist, kann der Einkopplungsfokus beispielsweise im Bereich einer Zwischenfokusumlenkoptik eines Strahlfeldführungssystems angeordnet sein.

Ein weiterer Aspekt der Erfindung betrifft einen Scheibenlaser mit einer Pumplichtanordnung wie weiter oben beschrieben sowie mit einem laseraktiven Medium in Form einer Laserscheibe. Der Scheibenlaser (oder ggf. der Scheibenlaserverstärker) weist typischer Weise einen Resonator auf, der z.B. zwischen einer verspiegelten Rückseite des laseraktiven Mediums (Laserscheibe) und einem Element zum Auskoppeln von Laserstrahlung bzw. eines Laserstrahls gebildet sein kann und bei dem es sich z.B. um einen (teildurchlässigen) Auskoppelspiegel handeln kann. In dem Resonator wird Laserstrahlung mit einer Wellenlänge erzeugt, die von der Art des laseraktiven Mediums abhängig ist, wobei die Wellenlänge der von dem laseraktiven Medium erzeugten Laserstrahlung typischer Weise von der Wellenlänge der Pumplichtquelle abweicht. Das laseraktive Medium des Scheibenlasers wird vom Pumplichtstrahl mehrfach durchsetzt, ohne dass hierbei zu große Verluste durch Abschneide-Effekte bzw. durch Abbildungsfehler auftreten, wodurch die Effizienz des Scheibenlasers gesteigert werden kann.

Ein weiterer Aspekt der Erfindung betrifft ein Verfahren zum Pumpen eines laseraktiven Mediums der eingangs genannten Art, bei dem eine Anzahl von Umlenkungen zwischen zwei Reflexionsbereichen der beiden Ringbereiche mit einer Bildumkehr des Pumplichtstrahls in radialer Richtung zur Mittelachse vorgenommen wird, die mindestens einem Drittel, bevorzugt mindestens der Hälfte der Gesamtzahl von Umlenkungen zwischen zwei Reflexionsbereichen der beiden Ringbereiche entspricht. Wie oben beschrieben wurde, können auf diese Weise Abbildungsfehler bei aufeinander folgenden Fokussierungen (nahezu) vollständig kompensiert werden, so dass einer Vergrößerung des kollimierten Strahldurchmessers entgegen gewirkt wird und auf diese Weise die Effizienz beim Pumpen des laseraktiven Mediums gesteigert werden kann.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine schematische Darstellung eines Ausführungsbeispiels eines Scheibenlasers mit einer Pumplichtanordnung,
- Fig. 2: eine schematische Darstellung des Strahlverlaufs von drei Strahlenbündeln eines Pumplichtstrahls ausgehend von der Eintrittspupille, die unter unterschiedlichen Einfallswinkeln auf eine parabolische Reflexionsfläche treffen,
- Fig. 3a,b: schematische Darstellungen der Abhängigkeit der Brennweite der Reflexionsfläche vom Einfallswinkel sowie der Abhängigkeit des Neigungswinkels einer Pupillenebene des Pumplichtstrahls vom Abstand von einer Mittelachse der Reflexionsfläche,
- Fig. 4: eine schematische Darstellung analog zu Fig. 2 mit einer Umlenkeinrichtung, die eine Bildumkehr in radialer Richtung bewirkt,
- Fig. 5: eine Darstellung einer Reflexionsfläche der Pumplichtanordnung mit Reflexionsbereichen, die in drei Ringbereichen angeordnet sind, sowie mit einer Umlenkanordnung mit Umlenkeinrichtungen zur Umlenkung des Pumplichtstrahls zwischen jeweils zwei der Reflexionsbereiche, sowie
- Fig. 6: eine Darstellung einer Umlenkeinrichtung, welche ein Dachkantprisma zur vollständigen Bildumkehr des Pumplichtstrahls aufweist.

In der folgenden Beschreibung der Zeichnungen werden für gleiche bzw. funktionsgleiche Bauteile identische Bezugszeichen verwendet.

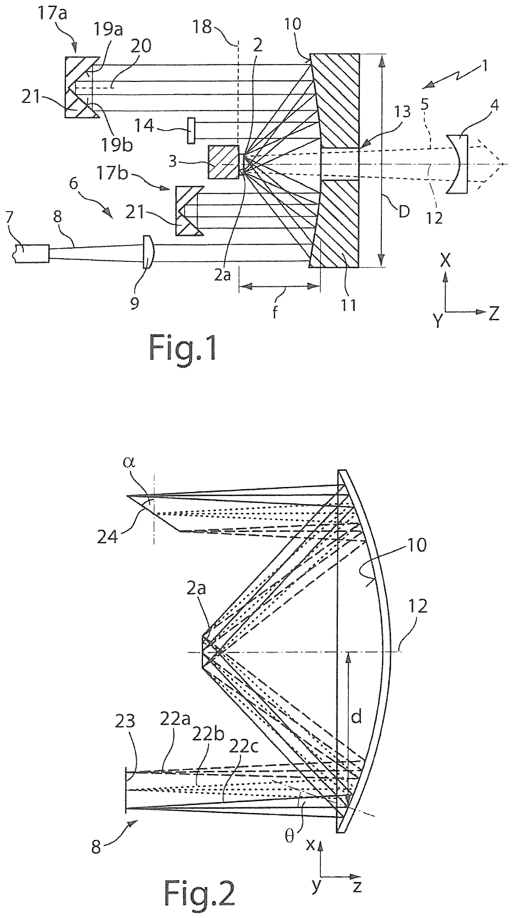

**Fig. 1** zeigt beispielhaft einen Scheibenlaser 1, welcher ein laseraktives Medium 2 in Form einer Laserscheibe aufweist, die zur Kühlung auf einer Wärmesenke 3 angeordnet ist. An der der Wärmesenke 3 zugewandten Seite der Laserscheibe 2 ist eine reflektierende Beschichtung 2a aufgebracht, die zusammen mit einem teildurchlässigen Auskoppelspiegel 4 einen Resonator für durch Anregung des laseraktiven Mediums 2 erzeugte Laserstrahlung 5 bildet, welche den Resonator durch den teildurchlässigen Auskoppelspiegel 4 verlässt, wie in Fig. 1 durch einen Pfeil angedeutet ist.

Zur Anregung des laseraktiven Mediums 2 weist der Scheibenlaser 1 eine Pumplichtanordnung 6 mit einer Pumplichtquelle 7 auf, welche einen zunächst divergenten Pumplichtstrahl 8 erzeugt, der an einer in Fig. 1 zur Vereinfachung in Form einer einzelnen Linse 9 dargestellten Kollimationsoptik kollimiert wird. Der kollimierte Pumplichtstrahl 8 trifft auf eine Reflexionsfläche 10, welche an einem Hohlspiegel 11 gebildet ist. Die Reflexionsfläche 10 verläuft drehsymmetrisch zu einer Mittelachse 12 des Hohlspiegels 11 und ist parabelförmig gekrümmt, d.h. der Hohlspiegel 11 bildet einen Parabolspiegel. Der kollimierte Pumplichtstrahl 8 trifft parallel zur Mittelachse 12 des Hohlspiegels 11 auf die Reflexionsfläche 10. Der Hohlspiegel 11 weist eine zentrische Öffnung 13 zum Durchtritt für die in dem laseraktiven Medium 2 erzeugte Laserstrahlung 5 auf.

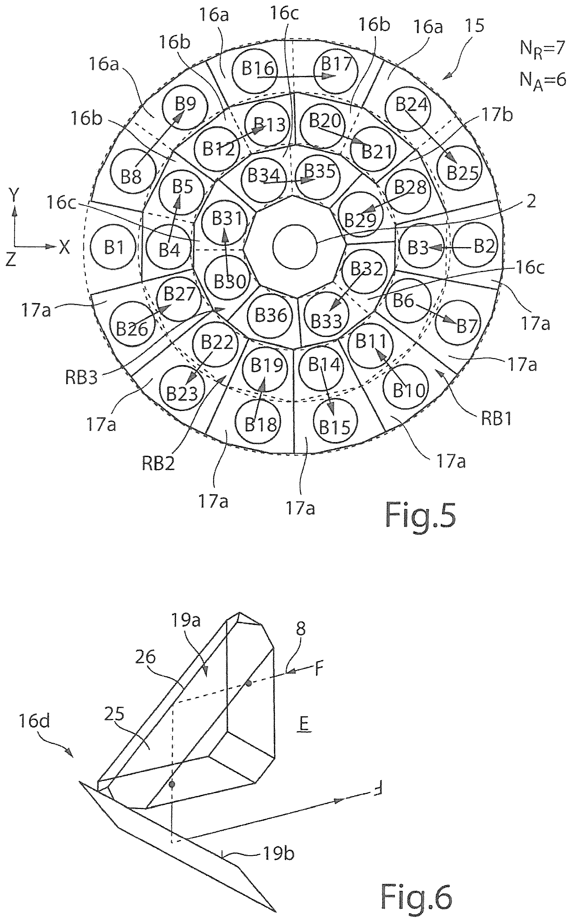

Der kollimierte Pumplichtstrahl 8 wird an der parabolischen Reflexionsfläche 10 reflektiert und auf das im Brennpunkt bzw. der Brennebene 18 des Hohlspiegels 11 (mit Brennweite f) angeordnete laseraktive Medium 2 fokussiert. Hierbei wird eine Strahlaustrittsfläche der Pumplichtquelle 7 auf das laseraktive Medium 2 in der Brennebene 18 in einem Abbildungsmaßstab abgebildet, welcher durch die Brennweite f des Parabolspiegels 11 und die (nicht gezeigte) Brennweite der Kollimationslinse 9 festgelegt ist. Der Pumplichtstrahl 8 wird nachfolgend an der reflektierenden Beschichtung 2a an der Rückseite des laseraktiven Mediums 2 reflektiert, trifft divergent auf die Reflexionsfläche 10 und wird an dieser erneut reflektiert. Der reflektierte Pumplichtstrahl 8 wird aufgrund der parabelförmigen Geometrie der Reflexionsfläche 10 kollimiert und trifft nachfolgend auf eine Umlenkanordnung 15, die weiter unten im Zusammenhang mit **Fig. 5** im Detail dargestellt ist.

**Fig. 2** zeigt den Strahlengang des Pumplichtstrahls 8, genauer gesagt von drei Strahlenbündeln 22a-c des Pumplichtstrahls 8, zwischen einer Eintritts-Pupillenebene 23 und einer weiteren Pupillenebene 24. Die drei Strahlenbündel 22a-c sind in radialer Richtung (entsprechend der X-Richtung von Fig. 2) unterschiedlich weit von der Mittelachse 12 der Reflexionsfläche 10 entfernt und treffen daher mit unterschiedlichen Einfallswinkeln θ auf die Reflexionsfläche 10 auf, wobei in Fig. 2 zur Vereinfachung lediglich der Einfallswinkel θ des dritten, radial äußersten Strahlenbündels 22c gezeigt ist. Wie in Fig. 2 zu erkennen ist, ist die weitere Pupillenebene 24, die nach der Fokussierung der Strahlenbündel 22a-c auf die reflektierende Beschichtung 2a des laseraktiven Mediums 2 und der erneuten Kollimierung an der Reflexionsfläche 10 von den Strahlenbündeln 22a-c bzw. vom Pumplichtstrahl 8 gebildet wird, bezüglich einer Ebene (XY-Ebene) senkrecht zur Mittelachse 12, die sich in Z-Richtung erstreckt, unter einem Neigungswinkel α geneigt bzw. verkippt.

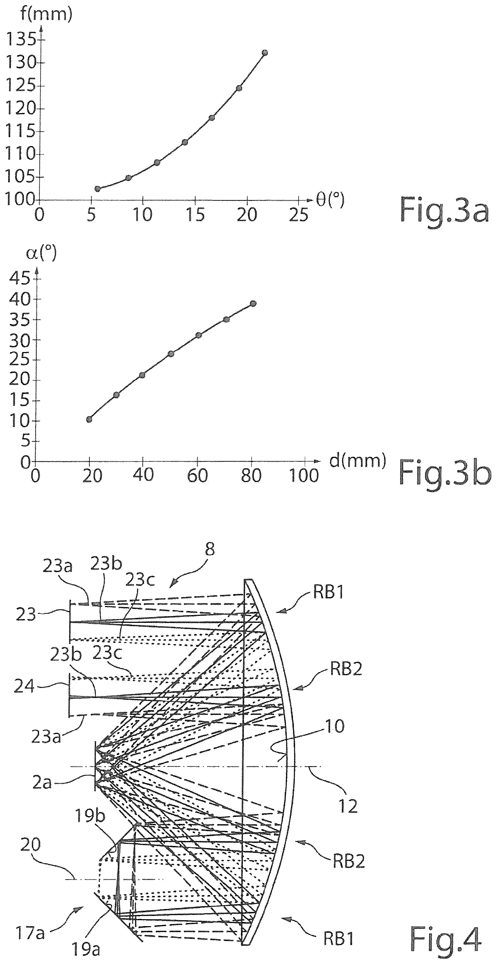

Die Ursache für die Neigung der weiteren Pupillenebene 24 liegt in der Abhängigkeit der Brennweite f (vgl. Fig. 1) der parabolischen Reflexionsfläche 10 vom Einfallswinkel θ, die im gezeigten Beispiel nominell bei f = 100 mm liegt, die aber gemäß **Fig. 3a** im Wesentlichen quadratisch mit dem Einfallswinkel θ zunimmt. Da der Einfallswinkel θ mit zunehmendem Abstand d des Pumplichtstrahls 8 von der Mittelachse 12 zunimmt, nimmt der Neigungswinkel α der weiteren Pupillenebene 24 mit zunehmendem Abstand d von der Mittelachse 12 ebenfalls zu, wie dies in **Fig. 3b** gezeigt ist.

Durch die Neigung der weiteren Pupillenebene 24 kann die Telezentrie-Bedingung bei der (2f-)Abbildung des Pumplichtstrahls 8 nicht mehr gleichzeitig für alle in radialer Richtung unterschiedlich weit von der Mittelachse 12 verlaufenden Strahlenbündel 23a-c erfüllt werden. Typischer Weise werden die in Fig. 1 gezeigten Umlenkeinrichtungen 17a, 17b der Umlenkanordnung 25 (vgl. Fig. 5) in einem solchen Abstand von der Reflexionsfläche 10 angeordnet, dass die Telezentriebedingung im Mittel erfüllt ist, d.h. typischer Weise weist das mittlere Strahlenbündel 23b eine ideale Telezentrie auf, so dass nur das mittlere Strahlenbündel 23b bei mehreren Umlenkungen reproduziert wird, während alle anderen Strahlenbündel, insbesondere das radial am weitesten innen liegende Strahlenbündel 23a und das radial am weitesten außen liegende Strahlenbündel 23c, einen instabilen Strahlengang aufweisen. Dies führt dazu, dass diese beiden äußeren Strahlenbündel 23a, 23c sich bei einer Mehrzahl von aufeinander folgenden Fokussierungen aufweiten, wobei die Aufweitung mit der Anzahl der Fokussierungen zunimmt. Diese Aufweitung kann dazu führen, dass der Strahlquerschnitt des Pumplichtstrahls 8 so groß wird, dass es zu Abschneideverlusten an den in Fig. 1 gezeigten Umlenkeinrichtungen 17a, 17b kommt, da der Pumplichtstrahl 8 die Umlenkflächen 19a, 19b der Umlenkeinrichtungen 17a, 17b überstrahlt.

Um den in Fig. 2 beschriebenen Abbildungsfehler zu korrigieren, so dass die (weitere) Pupillenebene 24 einen Neigungswinkel α von (annähernd) 0° aufweist, kann eine radiale Bildumkehr des Pumplichtstrahls 8 an einer radialen Umlenkeinrichtung 17a mit zwei Umlenkflächen 19a, 19b vorgenommen werden, die jeweils eine Umlenkung des Pumplichtstrahls 8 um 90° bewirken, wie dies in Fig. 4 dargestellt ist. Der von der Eintrittspupille 23 ausgehende Pumplichtstrahl 8, von dem in Fig. 4 analog zu Fig. 2 drei Strahlenbündel 23a-c gezeigt sind, trifft in einem ersten, radial außen liegenden Ringbereich RB1 auf die Reflexionsfläche 10, wird an dieser auf das laseraktive Medium 2 fokussiert, von der reflektierenden Beschichtung 2a des laseraktiven Mediums 2 zum ersten Ringbereich RB1 zurück reflektiert und von diesem parallel zur Mittelachse 12 zur Umlenkeinrichtung 17a hin umgelenkt.

An den beiden spiegelsymmetrisch zu einer Symmetrieebene 20 angeordneten Umlenkflächen 19a, 19b der radialen Umlenkeinrichtung 17a erfolgt eine zweimalige 90°-Umlenkung des Pumplichtstrahls 8. Die 180°-Umlenkung an der radialen Umlenkeinrichtung 17a erfolgt in radialer Richtung, so dass der von der Umlenkeinrichtung 17a zurück reflektierte Pumplichtstrahl 8 parallel zur Mittelachse 12 in einen zweiten, radial weiter innen liegenden Ringbereich RB2 umgelenkt wird. Die Umlenkeinrichtung 17a erzeugt auch eine Bildumkehr des Pumplichtstrahls 8, genauer gesagt des Strahlquerschnitts des Pumplichtstrahls 8, und zwar eine Spiegelung des Strahlquerschnitts des Pumplichtstrahls 8 an der Symmetrieebene 20. Die Symmetrieebene 20 verläuft im gezeigten Beispiel in azimutaler Richtung, so dass die Bildumkehr des Pumplichtstrahls 8 in radialer Richtung erfolgt.

Die radiale Bildumkehr führt dazu, dass das erste Strahlenbündel 23a, welches vor der Umlenkung an der radialen Umlenkeinrichtung 17a radial außen verläuft, nach der 180°-Umlenkung an der radialen Umlenkeinrichtung 17a radial innen verläuft. Entsprechend verläuft das dritte Strahlenbündel 23c, welches vor der Umlenkung an der radialen Umlenkeinrichtung 17a radial innen verläuft, nach der Umlenkung radial außen. Bei der anschließenden Fokussierung des Pumplichtstrahls 8 auf das laseraktive Medium 2 und der Kollimierung und Umlenkung an dem zweiten Ringbereich RB2 wird der weiter oben beschriebene Abbildungsfehler weitgehend korrigiert, so dass die (weitere) Pupillenebene 24 annähernd in einer Ebene senkrecht zur Mittelachse 11 verläuft, d.h. einen (nahezu) verschwindenden Neigungswinkel (α = 0°) aufweist. Durch eine Umlenkanordnung 15, die eine abwechselnde Umlenkung des Pumplichtstrahls in radialer Richtung (mit radialer Bildumkehr) und in azimutaler Richtung (ohne radiale Bildumkehr) erzeugt, kann somit der oben beschriebene Abbildungsfehler bei der Umlenkung am ersten und zweiten Ringbereich RB1, RB2 nahezu vollständig kompensiert werden, wie nachfolgend anhand von Fig. 5 für eine Umlenkanordnung 15 mit drei Ringbereichen RB1 bis RB3 beschrieben wird.

Die in Fig. 5 gezeigte Umlenkanordnung 15 weist eine Mehrzahl von Umlenkeinrichtungen 16a-c, 17a,b auf, die ausgebildet sind, den Pumplichtstrahl 8 zwischen jeweils zwei ebenfalls in Fig. 5 dargestellten Reflexionsbereichen B1 bis B36 der Reflexionsfläche 10 umzulenken. Die Bezeichnung der Reflexionsbereiche B1 bis B36 entspricht der Reihenfolge, in der diese von dem Pumplichtstrahl 8 durchlaufen werden. Wie in Fig. 5 zu erkennen ist, sind die Reflexionsbereiche B1 bis B36 in einem ersten bis dritten Ringbereich RB1 bis RB3 um die Mittelachse 12 der Reflexionsfläche 10 angeordnet. Der erste, radial außen liegende Ringbereich RB1 und der zweite Ringbereich RB2, der in radialer Richtung an den ersten Ringbereich RB2 angrenzt, weisen jeweils eine Anzahl von vierzehn Reflexionsbereichen auf, die in azimutaler Richtung (d.h. in Umfangsrichtung) in unterschiedlichen Winkelbereichen bzw. Kreissektoren angeordnet sind. Der dritte, radial innen liegende Ringbereich RB3 weist eine Anzahl von acht Reflexionsbereichen auf, die ebenfalls in azimutaler Richtung in unterschiedlichen Winkelbereichen angeordnet sind. Der Pumplichtstrahl 8 durchläuft der Reihe nach die Reflexionsbereiche B1 bis B36 und wird hierbei sowohl an dem laseraktiven Medium 2 als auch an der in Fig. 5 gezeigten Umlenkanordnung 15 umgelenkt, wie nachfolgend im Einzelnen beschrieben wird:
Der Pumplichtstrahl 8 trifft zunächst kollimiert auf einen ersten Reflexionsbereich B1 der Reflexionsfläche 10, der an dem ersten Ringbereich RB1 gebildet ist, wird von dem ersten Reflexionsbereich B1 auf das laseraktive Medium 2 fokussiert und trifft an einem zweiten Reflexionsbereich B2 des ersten Ringbereichs RB1 erneut auf die Reflexionsfläche 10. Der Pumplichtstrahl 8 wird an dem zweiten Reflexionsbereich B2 reflektiert und verlässt diesen kollimiert und parallel zur Mittelachse 12 und trifft auf eine radiale Umlenkeinrichtung 17a der Umlenkanordnung 15, wie dies in Fig. 1 zu erkennen ist. Der Pumplichtstrahl 8 wird an der radialen Umlenkeinrichtung 17a umgelenkt, wobei die Propagationsrichtung des Pumplichtstrahls 8 umgekehrt und ein radialer Strahlversatz des Pumplichtstrahls 8 erzeugt wird.

Der Pumplichtstrahl 8 wird hierbei von dem zweiten Reflexionsbereich B2 in dem ersten Ringbereich RB1 zu einem dritten Reflexionsbereich B3 in dem zweiten Ringbereich RB2 der Reflexionsfläche 10 umgelenkt, wie in Fig. 5 zu erkennen ist. Der zweite und der dritte Reflexionsbereich B2, B3 sind in radialer Richtung benachbart angeordnet. Die radiale Umlenkeinrichtung 17a zur Umlenkung des Pumplichtstrahls 8 vom zweiten Reflexionsbereich B2 zum dritten Reflexionsbereich B3 weist im gezeigten Beispiel ein Biprisma 21 auf, welches wie in Fig. 1 bzw. in Fig. 4 gezeigt zwei symmetrisch zu einer gemeinsamen Symmetrieebene 20 ausgerichtete plane Umlenkflächen 19a, 19b aufweist. Im gezeigten Beispiel weisen alle Umlenkeinrichtungen 16a-c, 17a,b der Umlenkanordnung 15 eine identische Bauform auf, d.h. diese sind jeweils als Biprismen ausgebildet. Insgesamt existieren in der Umlenkanordnung 15 zwei Typen von radialen Umlenkeinrichtungen 17a,b sowie drei Typen von azimutalen Umlenkeinrichtungen 16a-c zur Umlenkung des Pumplichtstrahls 8 zwischen den jeweiligen Reflexionsbereichen B1 bis B36, die sich lediglich in ihren Abmessungen sowie in ihrer Ausrichtung voneinander unterscheiden.

Der Pumplichtstrahl 8 wird nachfolgend von dem dritten Reflexionsbereich B3 auf das laseraktive Medium 2 fokussiert und trifft nach der Reflexion an der reflektierenden Beschichtung 2a auf einen vierten Reflexionsbereich B4, der ebenfalls an dem zweiten Ringbereich RB2 der Reflexionsfläche 10 gebildet ist, vgl. Fig. 2. Der Pumplichtstrahl 8 wird von einer azimutalen Umlenkeinrichtung 16b der Umlenkanordnung 15 in azimutaler Richtung zu einem benachbarten, fünften Reflexionsbereich B5 des zweiten Ringbereichs RB2 umgelenkt.

Der Pumplichtstrahl 8 wird von dem fünften Reflexionsbereich B5 zum laseraktiven Medium 2 und von dort zu einem sechsten Reflexionsbereich B6 des zweiten Ringbereichs RB2 reflektiert und nachfolgend mittels einer weiteren radialen Umlenkeinrichtung 17a in radialer Richtung zu einem siebten Reflexionsbereich B7 in dem ersten Ringbereich RB1 umgelenkt. Die weitere radiale Umlenkeinrichtung 17a ist baugleich zur radialen Umlenkeinrichtung 17a, welche zur Umlenkung des Pumplichtstrahls 8 zwischen dem zweiten und dem dritten Reflexionsbereich B2, B3 dient. Der Pumplichtstrahl 8 wird nachfolgend über das laseraktive Medium 2 auf einen achten Reflexionsbereich B8 in dem ersten Ringbereich RB1 umgelenkt. Eine azimutale Umlenkeinrichtung 16a dient zur Umlenkung des Pumplichtstrahls 8 in azimutaler Richtung von dem achten Reflexionsbereich B8 zu einem neunten, unmittelbar benachbarten Reflexionsbereich B9 des ersten Ringbereichs RB1.

Von dem neunten Reflexionsbereich B9 wird der Pumplichtstrahl 8 über das laseraktive Medium 2 zu einem zehnten Reflexionsbereich B10 des ersten Ringbereichs RB1 umgelenkt. Nachfolgend wird der Pumplichtstrahl 8 wie weiter oben beschrieben erneut in radialer Richtung von dem zehnten Reflexionsbereich B10 zu einem elften Reflexionsbereich B11 des zweiten Ringbereichs RB2 umgelenkt. Die abwechselnde Umlenkung des Pumplichtstrahls 8 in radialer Richtung zwischen zwei Reflexionsbereichen B10, B11; B14, B15; B18, B19; B22, B23; B26, B27 der beiden Ringbereiche RB1, RB2 mit Hilfe einer jeweiligen radialen Umlenkeinrichtung 17a und in azimutaler Richtung zwischen jeweils zwei Reflexionsbereichen B16, B17; B24, B25 des ersten Ringbereichs RB1 bzw. zwischen zwei Reflexionsbereichen B12, B13; B20, B21 des zweiten Ringbereichs RB2 mit Hilfe von azimutalen Umlenkeinrichtungen 16a, 16b wird nachfolgend wiederholt, bis der Pumplichtstrahl 8 einen achtundzwanzigsten Reflexionsbereich B28 des zweiten Ringbereichs RB2 erreicht hat (vgl. Fig. 5).

Von dort wird der Pumplichtstrahl 8 mittels einer radialen Umlenkeinrichtung 17b in radialer Richtung zu einem radial benachbarten Reflexionsbereich B29 des dritten Ringbereichs RB3 umgelenkt. Nachfolgend wird der Pumplichtstrahl 8 auf die weiter oben beschriebene Weise zwischen jeweils zwei in azimutaler Richtung benachbarten Reflexionsbereichen B30, B31; B32, B33; B34, B35 des dritten Ringbereichs RB3 umgelenkt, wobei zwischen zwei azimutalen Umlenkungen jeweils eine Fokussierung auf das laseraktive Medium 2 erfolgt.

Von einem sechsunddreißigsten Reflexionsbereich B36 wird der Pumplichtstrahl 8 zu einem Endspiegel 14 (vgl. Fig. 1) umgelenkt, welcher den Pumplichtstrahl 8 in sich zurück reflektiert, so dass der Pumplichtstrahl 8 die Reflexionsbereiche B1 bis B36 in umgekehrter Richtung entlang desselben Strahlwegs erneut durchläuft. Der Pumplichtstrahl 8 durchläuft auf diese Weise das laseraktive Medium 2 insgesamt zweiundsiebzig Mal. Es versteht sich, dass sowohl der Endspiegel 14 als auch die radiale Umlenkeinrichtung 17b zur Umlenkung des Pumplichtstrahls 8 in den dritten Ringbereich RB3 in Fig. 1 nur zur Vereinfachung der Darstellung in der Zeichenebene dargestellt sind und dass diese in unterschiedlichen Winkelbereichen um die Mittelachse 12 angeordnet sind, wie dies in Fig. 2 zu erkennen ist.

Bei der weiter oben beschriebenen Umlenkeinrichtung 15 wird der Pumplichtstrahl 8 alternierend in azimutaler Richtung zwischen jeweils zwei (azimutal benachbarten) Reflexionsbereichen B8, B9; B16, B17; B24, B25 des ersten Ringbereichs RB1 bzw. zwischen zwei (azimutal benachbarten) Reflexionsbereichen B4, B5; B12, B13; B20, B21 des zweiten Ringbereichs RB2 umgelenkt. Die Anzahl N_{R} der radialen Umlenkungen zwischen dem ersten und dem zweiten Ringbereich RB1, RB2 liegt im gezeigten Beispiel bei N_{R} = 7. Die Anzahl N_{A} der azimutalen Umlenkungen im ersten Ringbereich RB1 und im zweiten Ringbereich RB2 liegt insgesamt bei N_{A} = 6, d.h. die Anzahl der azimutalen Umlenkungen N_{A} weicht um Eins von der Anzahl der radialen Umlenkungen N_{R} in dem ersten und zweiten Ringbereich RB1, RB2 ab.

Eine möglichst gleichmäßige Aufteilung der Gesamtzahl N_{R} + N_{A} der Umlenkungen auf die Umlenkungen N_{R} in radialer Richtung und die Umlenkungen N_{A} in azimutaler Richtung ist bei dem ersten und zweiten radial außen liegenden Ringbereich RB1, RB2 günstig, da Abbildungsfehler, die zu einer Strahlaufweitung führen, bei der Umlenkung zwischen Reflexionsbereichen B1 bis B36 mit zunehmendem Abstand von der Mittelachse 12 der Reflexionsfläche 10 zunehmen (s.o.). Durch die im Wesentlichen gleichmäßige Aufteilung der Gesamtzahl N_{R} + N_{A} der Umlenkungen auf Umlenkungen N_{R} in radialer Richtung und auf Umlenkungen N_{A} in azimutaler Richtung im ersten und zweiten Ringbereich RB1, RB2 mittels der radialen Umlenkeinrichtungen 17a bzw. der azimutalen Umlenkeinrichtungen 16a,b können die Abbildungsfehler bzw. die Strahlaufweitung bei der Reflexion des Pumplichtstrahls 8 größtenteils kompensiert werden und auf diese Weise eine erhöhte Effizienz der Pumplichtanordnung 6 bzw. eines mit dieser versehenen Scheibenlasers 1 erreicht werden. Da der dritte, radial innen liegende Ringbereich RB3 in einem geringeren Abstand zur Mittelachse 12 angeordnet ist, kann dort eine rein azimutale Umlenkung des Pumplichtstrahls 8 erfolgen, ohne dass hierbei zu große Abbildungsfehler auftreten.

Es versteht sich, dass die Umlenkeinrichtungen 16a-c, 17a,b abweichend von der weiter oben beschriebenen Bauart ausgebildet sein können: Beispielsweise können an Stelle eines Biprismas 21 zwei einzelne Prismen jeweils mit einer verspiegelten Umlenkfläche 19a, 19b verwendet werden. Auch die Verwendung von zwei unter einem Winkel von 90° zueinander ausgerichteten Umlenkflächen, die an zwei Spiegeln gebildet sind, ist möglich. Die Umlenkeinrichtungen können beispielsweise auch als 180°-Umlenkprismen unter Ausnutzung von Totalreflexion an den als Umlenkflächen dienenden Kathetenflächen ausgebildet sein. Gegebenenfalls können als Umlenkeinrichtungen auch Faserbündel oder dergleichen verwendet werden.

**Fig. 6** zeigt eine azimutale Umlenkeinrichtung 16d, die zwei Umlenkflächen 19a, 19b aufweist, von denen die zweite Umlenkfläche 19b zur 90°-Umlenkung an einem Spiegel oder an einem Prisma gebildet ist. Die erste Umlenkfläche 19a ist an einem Dachkantprisma 25 gebildet, an dessen Dachkante 26 der Pumplichtstrahl 8 durch Totalreflexion um 90° umgelenkt wird, so dass insgesamt eine 180°-Umlenkung des Pumplichtstrahls 8 erzeugt wird. Durch die Verwendung des Dachkantprismas 25 in der Umlenkeinrichtung 16d wird bei der 180°-Umlenkung eine zusätzliche Bildumkehr bzw. Spiegelung an der Einfallsebene E (der Umlenkebene) des Pumplichtstrahls 8 erzeugt, die gemeinsam mit der Bildumkehr an der in Fig. 6 nicht bildlich dargestellten Symmetrieebene 20 eine vollständige Bildumkehr des Pumplichtstrahls 8 bewirkt, d.h. der Strahlquerschnitt des Pumplichtstrahls 8 wird um 180° gedreht. Die Wirkung der vollständigen Bildumkehr ist in Fig. 6 durch zwei Darstellungen des Buchstabens "F" angedeutet.

Durch die zusätzliche Bildumkehr bzw. Spiegelung an der Einfallsebene E bewirkt die in Fig. 6 gezeigte azimutale Umlenkeinrichtung 16d eine radiale Bildumkehr, so dass diese geeignet ist, den weiter oben beschriebenen Abbildungsfehler zu korrigieren. An Stelle der in Fig. 5 gezeigten Umlenkanordnung 15, bei der bei dem ersten und zweiten Ringbereich RB1, RB2 abwechselnd eine radiale und eine azimutale Umlenkung erfolgt, kann bei der Verwendung der in Fig. 6 gezeigten azimutalen Umlenkeinrichtung 16d eine Umlenkanordnung 15 gebildet werden, die analog zum dritten, inneren Ringbereich RB3 von Fig. 5 eine ausschließlich azimutale Umlenkung auch in dem ersten Ringbereich RB1 und in dem zweiten Ringbereich RB2 der Reflexionsfläche 10 erzeugt, ohne dass die hierbei auftretenden Abbildungsfehler zu groß werden. Es versteht sich, dass in diesem Fall nicht jede der azimutalen Umlenkeinrichtungen 16d zwingend ein Dachkantprisma 25 aufweisen muss; allerdings sollte beim mindestens einem Drittel, bevorzugt mindestens der Hälfte der Umlenkungen mit der Umlenkanordnung 15 eine radiale Bildumkehr erfolgen.

Um die Effizienz der Pumplichtanordnung 1 weiter zu erhöhen, kann die optische Weglänge zwischen jeweils zwei der Reflexionsbereiche beispielsweise auf die in der eingangs zitierten DE 10 2011 004 204 A1 beschriebene Weise optimiert werden. Gegebenenfalls kann die Linse 9 oder eine andere Einkoppeloptik so ausgelegt werden, dass an Stelle eines kollimierten Pumplichtstrahls 8 ein Pumplichtstrahl mit einem Einkoppelfokus erzeugt wird, wie dies in der weiter oben zitierten DE 10 2013 114 748 A1 beschrieben ist, welche durch Bezugnahme in ihrer Gesamtheit zum Inhalt dieser Anmeldung gemacht wird. In diesem Fall ist sind typischer Weise die Umlenkeinrichtungen 16a-d, 17a,b bzw. die Umlenkflächen 19a, 19b im Bereich eines Zwischenfokus angeordnet.

## Patentansprüche

1. Pumplichtanordnung (6) für einen Scheibenlaser (1), umfassend:
eine Fokussiereinrichtung, insbesondere einen Hohlspiegel (11), mit einer Reflexionsfläche (10) zur Fokussierung eines Pumplichtstrahls (8) auf ein laseraktives Medium (2), wobei die Reflexionsfläche (10) bevorzugt eine asphärische Form, insbesondere eine Parabelform, aufweist,
sowie
eine Umlenkanordnung (15) zur Umlenkung des Pumplichtstrahls (8) zwischen an der Reflexionsfläche (10) gebildeten Reflexionsbereichen (B1 bis B36), die in unterschiedlichen Winkelbereichen um eine Mittelachse (12) der Reflexionsfläche (10) in mindestens einem ersten Ringbereich (RB1) und einem zweiten Ringbereich (RB2) angeordnet sind,
wobei die Umlenkanordnung (15) ausgebildet ist, mindestens eine Umlenkung des Pumplichtstrahls (8) zwischen zwei Reflexionsbereichen (B8, B9; B16, B17; B24, B25) des ersten Ringbereichs (RB1) und mindestens eine Umlenkung zwischen zwei Reflexionsbereichen (B4, B5; B12, B13; B20, B21) des zweiten Ringbereichs (RB2) vorzunehmen,
**dadurch gekennzeichnet,**
**dass** die Umlenkanordnung (15) ausgebildet ist, eine Anzahl (N_{R}) von Umlenkungen zwischen zwei Reflexionsbereichen (B2 bis B28) der beiden Ringbereiche (RB1, RB2) mit einer Bildumkehr des Pumplichtstrahls (8) in radialer Richtung zur Mittelachse (12) vorzunehmen, die mindestens einem Drittel, bevorzugt mindestens der Hälfte der Gesamtzahl (N_{R} + N_{A}) von Umlenkungen zwischen zwei Reflexionsbereichen (B2 bis B28) der beiden Ringbereiche (RB1, RB2) entspricht.

2. Pumplichtanordnung nach Anspruch 1, bei der die Umlenkanordnung (15) ausgebildet ist, zur Bildumkehr des Pumplichtstrahls (8) in radialer Richtung zur Mittelachse (12) eine Umlenkung des Pumplichtstrahls (8) von einem Reflexionsbereich (B2, B10, B18, B26) des ersten Ringbereichs (RB1) auf einen Reflexionsbereich (B3, B11, B19, B27) des zweiten Ringbereichs (RB2) oder umgekehrt vorzunehmen.

3. Vorrichtung nach Anspruch 2, bei der die Umlenkeinrichtung (15) ausgebildet ist, zwischen jeder Umlenkung des Pumplichtstrahls (8) zwischen zwei Reflexionsbereichen (B8, B9; B16, B17; B24, B25) des ersten Ringbereichs (RB1) und jeder Umlenkung des Pumplichtstrahls (8) zwischen zwei Reflexionsbereichen (B4, B5; B12, B13; B20, B21) des zweiten Ringbereichs (RB2) eine Umlenkung des Pumplichtstrahls (8) von einem Reflexionsbereich (B2, B10, B18, B26) des ersten Ringbereichs (RB1) auf einen Reflexionsbereich (B3, B11, B19, B27) des zweiten Ringbereichs (RB2) oder umgekehrt vorzunehmen.

4. Pumplichtanordnung nach einem der vorhergehenden Ansprüche, bei der die Umlenkanordnung (15) ausgebildet ist, eine Anzahl (N_{R}) von Umlenkungen des Pumplichtstrahls (8) von einem Reflexionsbereich (B2, B10, B18, B26) des ersten Ringbereichs (RB1) auf einen Reflexionsbereich (B3, B11, B19, B27) des zweiten Ringbereichs (RB2) oder umgekehrt vorzunehmen, die von der Anzahl (N_{A}) von Umlenkungen zwischen zwei Reflexionsbereichen (B8, B9; B16, B17; B24, B25) des ersten Ringbereichs (RB1) und zwischen zwei Reflexionsbereichen (B4, B5; B12, B13; B20, B21) des zweiten Ringbereichs (RB2) um nicht mehr als Eins abweicht.

5. Pumplichtanordnung nach einem der vorhergehenden Ansprüche, bei welcher die Umlenkanordnung (15) mindestens eine Umlenkeinrichtung (16a-d; 17a,b) zur Umlenkung des Pumplichtstrahls (8) zwischen jeweils zwei Reflexionsbereichen (B1 bis B36) der Reflexionsfläche (10) aufweist, die zwei insbesondere spiegelsymmetrisch zu einer Symmetrieebene (20) ausgerichtete Umlenkflächen (19a, 19b) zur Bildumkehr des Pumplichtstrahls (8) bezüglich der Symmetrieebene (20) umfasst, wobei die Umlenkflächen (19a, 19b) bevorzugt an einem oder an mehreren Prismen (21) ausgebildet sind.

6. Pumplichtanordnung nach Anspruch 5, bei der mindestens eine Umlenkeinrichtung (16d) zur zusätzlichen Bildumkehr des Pumplichtstrahls (8) bezüglich einer Einfallsebene (E) des Pumplichtstrahls (8) ausgebildet ist.

7. Pumplichtanordnung nach Anspruch 5 oder 6, bei welcher eine der Umlenkflächen (19a) zur zusätzlichen Bildumkehr des Pumplichtstrahls (8) bezüglich einer Einfallsebene (E) des Pumplichtstrahls (8) an einem Dachkantprisma (25) gebildet ist.

8. Pumplichtanordnung nach einem der vorhergehenden Ansprüche, bei der die Umlenkanordnung (15) ausgebildet ist, die Umlenkung des Pumplichtstrahls (8) zwischen jeweils zwei azimutal benachbarten Reflexionsbereichen (B8, B9; B16, B17; B24, B25) des ersten Ringbereichs (RB1) und zwischen jeweils zwei azimutal benachbarten Reflexionsbereichen (B4, B5; B12, B13; B20, B21) des zweiten Ringbereichs (RB2) vorzunehmen.

9. Pumplichtanordnung nach einem der vorhergehenden Ansprüche, bei welcher die Umlenkanordnung (15) ausgebildet ist, die Umlenkung des Pumplichtstrahls (8) zwischen jeweils zwei radial benachbarten Reflexionsbereichen (B2, B3; B6, B7; B10, B11; B14, B15; B18, B19; B22, B23; B26, B27) des ersten Ringbereichs (RB1) und des zweiten Ringbereichs (RB2) vorzunehmen.

10. Pumplichtanordnung nach einem der vorhergehenden Ansprüche, bei welcher die Anzahl der Reflexionsbereiche (B1, B2, B7-B10, B15-B18, B23-B26; B3-B6, B11-B14, B19-B22, B27, B28) des ersten Ringbereichs (RB1) und des zweiten Ringbereichs (RB2) gleich groß ist, wobei bevorzugt sowohl der erste als auch der zweite Ringbereich (RB1, RB2) eine Anzahl von vierzehn Reflexionsbereichen (B1, B2, B7-B10, B15-B18, B23-B26; B3-B6, B11-B14, B19-B22, B27, B28) aufweisen.

11. Pumplichtanordnung nach einem der vorhergehenden Ansprüche, bei der die Reflexionsfläche (10) mindestens einen dritten, radial innen liegenden Ringbereich (RB3) umfasst, der von dem ersten und dem zweiten Ringbereich (RB1, RB2) der Reflexionsfläche (10) umgeben ist, wobei der dritte Ringbereich (RB1) bevorzugt eine Anzahl von acht Reflexionsbereichen (B29 bis B36) aufweist.

12. Pumplichtanordnung nach Anspruch 11, bei welcher die Umlenkanordnung (15) ausgebildet ist, den Pumplichtstrahl (8) mindestens zwei Mal unmittelbar aufeinander folgend zwischen jeweils zwei Reflexionsbereichen (B30, B31; B32, B33; B34, B35) des dritten Ringbereichs (RB3) umzulenken.

13. Pumplichtanordnung nach einem der vorhergehenden Ansprüche, weiter umfassend: eine Pumplichtquelle (7) zur Erzeugung des Pumplichtstrahls (8), wobei bevorzugt im Strahlengang zwischen der Pumplichtquelle (7) und der Reflexionsfläche (10) eine Kollimationsoptik (9) zur Kollimation des Pumplichtstrahls (8) angeordnet ist.

14. Scheibenlaser (1), umfassend:
eine Pumplichtanordnung (6) nach einem der vorhergehenden Ansprüche, sowie ein laseraktives Medium in Form einer Laserscheibe (2).

15. Verfahren zum Pumpen eines scheibenförmigen laseraktiven Mediums (2), umfassend:
Mehrmaliges Fokussieren eines Pumplichtstrahls (8) auf das laseraktive Medium (2) mittels einer Fokussiereinrichtung (11), insbesondere mittels eines Hohlspiegels, wobei zwischen aufeinander folgenden Fokussierungsschritten eine Umlenkung des Pumplichtstrahls (8) zwischen unterschiedlichen Reflexionsbereichen (B1 bis B36) einer Reflexionsfläche (10) der Fokussiereinrichtung (11) erfolgt, die in unterschiedlichen Winkelbereichen um eine Mittelachse (12) der Reflexionsfläche (10) herum in mindestens einem ersten Ringbereich (RB1) und einem zweiten Ringbereich (RB2) angeordnet sind, wobei der Pumplichtstrahl (8) sowohl zwischen zwei Reflexionsbereichen (B8, B9; B16, B17; B24, B25) des ersten Ringbereichs (RB1) als auch zwischen zwei Reflexionsbereichen (B4, B5; B12, B13; B20, B21) des zweiten Ringbereichs (RB2) jeweils mindestens einmal umgelenkt wird,
**dadurch gekennzeichnet,**
**dass** eine Anzahl (N_{R}) von Umlenkungen zwischen zwei Reflexionsbereichen (B2 bis B28) der beiden Ringbereiche (RB1, RB2) mit einer Bildumkehr des Pumplichtstrahls (8) in radialer Richtung zur Mittelachse (12) vorgenommen wird, die mindestens einem Drittel, bevorzugt mindestens der Hälfte der Gesamtzahl (N_{R} + N_{A}) von Umlenkungen zwischen zwei Reflexionsbereichen (B2 bis B28) der beiden Ringbereiche (RB1, RB2) entspricht.

## Claims

1. Pumping light arrangement (6) for a disc laser (1), comprising:
a focusing device, in particular a hollow mirror (11), with a reflecting surface (10) for focusing a pumping light beam (8) onto a laser-active medium (2), wherein the reflecting surface (10) preferably has an aspherical form, in particular a parabolic form, and also
a deflecting arrangement (15) for deflecting the pumping light beam (8) between reflecting regions (B1 to B36) formed on the reflecting surface (10) that are arranged in different angle regions around a central axis (12) of the reflecting surface (10) in at least a first annular region (RB1) and a second annular region (RB2),
the deflecting arrangement (15) being designed to perform at least one deflection of the pumping light beam (8) between two reflecting regions (B8, B9; B16, B17; B24, B25) of the first annular region (RB1) and at least one deflection between two reflecting regions (B4, B5; B12, B13; B20, B21) of the second annular region (RB2),
**characterized**
**in that** the deflecting arrangement (15) is designed to perform a number (N_{R}) of deflections between two reflecting regions (B2 to B28) of the two annular regions (RB1, RB2) with an image reversal of the pumping light beam (8) in the radial direction in relation to the central axis (12) that corresponds to at least one third, preferably at least half, of the total number (N_{R} + N_{A}) of deflections between two reflecting regions (B2 to B28) of the two annular regions (RB1, RB2).

2. Pumping light arrangement according to Claim 1, in which the deflecting arrangement (15) is designed to perform a deflection of the pumping light beam (8) from a reflecting region (B2, B10, B18, B26) of the first annular region (RB1) onto a reflecting region (B3, B11, B19, B27) of the second annular region (RB2), or vice versa, for the image reversal of the pumping light beam (8) in the radial direction in relation to the central axis (12).

3. Device according to Claim 2, in which the deflecting device (15) is designed to perform a deflection of the pumping light beam (8) from a reflecting region (B2, B10, B18, B26) of the first annular region (RB1) onto a reflecting region (B3, B11, B19, B27) of the second annular region (RB2), or vice versa, between each deflection of the pumping light beam (8) between two reflecting regions (B8, B9; B16, B17; B24, B25) of the first annular region (RB1) and each deflection of the pumping light beam (8) between two reflecting regions (B4, B5; B12, B13; B20, B21) of the second annular region (RB2).

4. Pumping light arrangement according to one of the preceding claims, in which the deflecting arrangement (15) is designed to perform a number (N_{R}) of deflections of the pumping light beam (8) from a reflecting region (B2, B10, B18, B26) of the first annular region (RB1) onto a reflecting region (B3, B11, B19, B27) of the second annular region (RB2), or vice versa, that deviates by no more than one from the number (N_{A}) of deflections between two reflecting regions (B8, B9; B16, B17; B24, B25) of the first annular region (RB1) and between two reflecting regions (B4, B5; B12, B13; B20, B21) of the second annular region (RB2).

5. Pumping light arrangement according to one of the preceding claims, in which the deflecting arrangement (15) comprises at least one deflecting device (16a-d; 17a,b) for deflecting the pumping light beam (8) between two reflecting regions (B1 to B36) in each case of the reflecting surface (10) which comprises two deflecting faces (19a, 19b) that are in particular aligned mirror-symmetrically in relation to a plane of symmetry (20) for the image reversal of the pumping light beam (8) with respect to the plane of symmetry (20), wherein the deflecting faces (19a, 19b) are preferably formed on one or more prisms (21).

6. Pumping light arrangement according to Claim 5, in which at least one deflecting device (16d) is designed for the additional image reversal of the pumping light beam (8) with respect to a plane of incidence (E) of the pumping light beam (8).

7. Pumping light arrangement according to Claim 5 or 6, in which one of the deflecting faces (19a) for the additional image reversal of the pumping light beam (8) with respect to a plane of incidence (E) of the pumping light beam (8) is formed on a roof prism (25) .

8. Pumping light arrangement according to one of the preceding claims, in which the deflecting arrangement (15) is designed to perform the deflection of the pumping light beam (8) between two azimuthally neighbouring reflecting regions (B8, B9; B16, B17; B24, B25) in each case of the first annular region (RB1) and between two azimuthally neighbouring reflecting regions (B4, B5; B12, B13; B20, B21) in each case of the second annular region (RB2).

9. Pumping light arrangement according to one of the preceding claims, in which the deflecting arrangement (15) is designed to perform the deflection of the pumping light beam (8) between two radially neighbouring reflecting regions (B2, B3; B6, B7; B10, B11; B14, B15; B18, B19; B22, B23; B26, B27) in each case of the first annular region (RB1) and of the second annular region (RB2).

10. Pumping light arrangement according to one of the preceding claims, in which the number of reflecting regions (B1, B2, B7-B10, B15-B18, B23-B26; B3-B6, B11-B14, B19-B22, B27, B28) of the first annular region (RB1) and the second annular region (RB2) is equal, wherein both the first and the second annular region (RB1, RB2) preferably have a number of fourteen reflecting regions (B1, B2, B7-B10, B15-B18, B23-B26; B3-B6, B11-B14, B19-B22, B27, B28).

11. Pumping light arrangement according to one of the preceding claims, in which the reflecting surface (10) comprises at least a third, radially inner annular region (RB3), which is surrounded by the first and second annular regions (RB1, RB2) of the reflecting surface (10), wherein the third annular region (RB1) preferably has a number of eight reflecting regions (B29 to B36).

12. Pumping light arrangement according to Claim 11, in which the deflecting arrangement (15) is designed to deflect the pumping light beam (8) at least twice directly in succession between two reflecting regions (B30, B31; B32, B33; B34, B35) in each case of the third annular region (RB3).

13. Pumping light arrangement according to one of the preceding claims, further comprising: a pumping light source (7) for producing the pumping light beam (8), wherein a collimating optics (9) is preferably arranged in the path of rays between the pumping light source (7) and the reflecting surface (10) for the collimation of the pumping light beam (8).

14. Disc laser (1), comprising:
a pumping light arrangement (6) according to one of the preceding claims, and also a laser-active medium in the form of a laser disc (2).

15. Method for pumping a disc-shaped laser-active medium (2), comprising:
repeatedly focusing a pumping light beam (8) onto the laser-active medium (2) by means of a focusing device (11), in particular by means of a hollow mirror, there taking place between successive focusing steps a deflection of the pumping light beam (8) between different reflecting regions (B1 to B36) of a reflecting surface (10) of the focusing device (11) that are arranged in different angle regions around a central axis (12) of the reflecting surface (10) in at least a first annular region (RB1) and a second annular region (RB2), the pumping light beam (8) being deflected at least once in each case both between two reflecting regions (B8, B9; B16, B17; B24, B25) of the first annular region (RB1) and between two reflecting regions (B4, B5; B12, B13; B20, B21) of the second annular region (RB2),
**characterized in that**
a number (N_{R}) of deflections between two reflecting regions (B2 to B28) of the two annular regions (RB1, RB2) with an image reversal of the pumping light beam (8) in the radial direction in relation to the central axis (12) that corresponds to at least one third, preferably at least half, of the total number (N_{R} + N_{A}) of deflections between two reflecting regions (B2 to B28) of the two annular regions (RB1, RB2) are performed.

## Revendications

1. Ensemble de lumière de pompage (6) pour un laser à disque (1), comprenant :
un moyen de focalisation, en particulier un miroir concave (11), doté d'une surface réfléchissante (10) pour focaliser un faisceau de lumière de pompage (8) sur un milieu laser actif (2), la surface réfléchissante (10) présentant de préférence une forme asphérique, en particulier une forme parabolique, et
un ensemble de déviation (15) pour dévier le faisceau de lumière de pompage (8) entre des zones réfléchissantes (B1 à B36) formées sur la surface réfléchissante (10), qui sont disposées dans différentes plages angulaires autour d'un axe central (12) de la surface réfléchissante (10) dans au moins une première zone annulaire (RB1) et une deuxième zone annulaire (RB2),
l'ensemble de déviation (15) étant conçu pour effectuer au moins une déviation du faisceau de lumière de pompage (8) entre deux zones réfléchissantes (B8, B9 ; B16, B17 ; B24, B25) de la première zone annulaire (RB1) et au moins une déviation entre deux zones réfléchissantes (B4, B5 ; B12, B13 ; B20, B21) de la deuxième zone annulaire (RB2),
**caractérisé en ce**
**que** l'ensemble de déviation (15) est conçu pour effectuer un nombre (N_{R}) de déviations entre deux zones réfléchissantes (B2 à B28) des deux zones annulaires (RB1, RB2) avec une inversion d'image du faisceau de lumière de pompage (8) dans la direction radiale par rapport à l'axe central (12) qui correspond à au moins un tiers, de préférence à au moins la moitié, du nombre total (N_{R} + N_{A}) de déviations entre deux zones réfléchissantes (B2 à B28) des deux zones annulaires (RB1, RB2).

2. Ensemble de lumière de pompage selon la revendication 1, dans lequel l'ensemble de déviation (15) est conçu, afin d'inverser l'image du faisceau de lumière de pompage (8) dans la direction radiale par rapport à l'axe central (12), pour effectuer une déviation du faisceau de lumière de pompage (8) d'une zone réfléchissante (B2, B10, B18, B26) de la première zone annulaire (RB1) vers une zone réfléchissante (B3, B11, B19, B27) de la deuxième zone annulaire (RB2) ou inversement.

3. Dispositif selon la revendication 2, dans lequel l'ensemble de déviation (15) est conçu pour effectuer entre chaque déviation du faisceau de lumière de pompage (8) entre deux zones réfléchissantes (B8, B9 ; B16, B17 ; B24, B25) de la première zone annulaire (RB1) et chaque déviation du faisceau de lumière de pompage (8) entre deux zones réfléchissantes (B4, B5 ; B12, B13 ; B20, B21) de la deuxième zone annulaire (RB2) une déviation du faisceau de lumière de pompage (8) d'une zone réfléchissante (B2, B10, B18, B26) de la première zone annulaire (RB1) vers une zone réfléchissante (B3, B11, B19, B27) de la deuxième zone annulaire (RB2) ou inversement.

4. Ensemble de lumière de pompage selon l'une des revendications précédentes, dans lequel l'ensemble de déviation (15) est conçu pour effectuer un nombre (N_{R}) de déviations du faisceau de lumière de pompage (8) d'une zone réfléchissante (B2, B10, B18, B26) de la première zone annulaire (RB1) vers une zone réfléchissante (B3, B11, B19, B27) de la deuxième zone annulaire (RB2) ou inversement, qui ne diffère pas de plus d'un du nombre (N_{A}) de déviations entre deux zones réfléchissantes (B8, B9 ; B16, B17 ; B24, B25) de la première zone annulaire (RB1) et entre deux zones réfléchissantes (B4, B5 ; B12, B13 ; B20, B21) de la deuxième zone annulaire (RB2).

5. Ensemble de lumière de pompage selon l'une des revendications précédentes, dans lequel l'ensemble de déviation (15) présente au moins un moyen de déviation (16ad ; 17a, b) pour dévier le faisceau de lumière de pompage (8) entre chaque fois deux zones réfléchissantes (B1 à B36) de la surface réfléchissante (10) qui comprend deux surfaces de déviation (19a, 19b), en particulier orientées symétriquement par rapport à un plan de symétrie (20) pour inverser l'image du faisceau de lumière de pompage (8) par rapport au plan de symétrie (20), les surfaces de déviation (19a, 19b) étant de préférence réalisées sur un ou plusieurs prismes (21).

6. Ensemble de lumière de pompage selon la revendication 5, dans lequel au moins un moyen de déviation (16d) est conçu pour inverser en plus l'image du faisceau de lumière de pompage (8) par rapport à un plan d'incidence (E) du faisceau de lumière de pompage (8).

7. Ensemble de lumière de pompage selon la revendication 5 ou 6, dans lequel l'une des surfaces de déviation (19a) pour inverser en plus l'image du faisceau de lumière de pompage (8) par rapport à un plan d'incidence (E) du faisceau de lumière de pompage (8) est formée sur un prisme en toit (25).

8. Ensemble de lumière de pompage selon l'une des revendications précédentes, dans lequel l'ensemble de déviation (15) est conçu pour effectuer la déviation du faisceau de lumière de pompage (8) entre chaque fois deux zones réfléchissantes (B8, B9 ; B16, B17 ; B24, B25) de la première zone annulaire (RB1) adjacentes dans une direction azimutale et entre chaque fois deux zones réfléchissantes (B4, B5 ; B12, B13 ; B20, B21) de la deuxième zone annulaire (RB2) adjacentes dans une direction azimutale.

9. Ensemble de lumière de pompage selon l'une des revendications précédentes, dans lequel l'ensemble de déviation (15) est conçu pour effectuer la déviation du faisceau de lumière de pompage (8) entre chaque fois deux zones réfléchissantes (B2, B3 ; B6, B7 ; B10, B11 ; B14, B15 ; B18, B19 ; B22, B23 ; B26, B27) radialement adjacentes de la première zone annulaire (RB1) et de la deuxième zone annulaire (RB2).

10. Ensemble de lumière de pompage selon l'une des revendications précédentes, dans lequel le nombre de zones réfléchissantes (B1, B2, B7-B10, B15-B18, B23-B26 ; B3-B6, B11-B14, B19-B22, B27, B28) de la première zone annulaire (RB1) et de la deuxième zone annulaire (RB2) est identique, la première et la deuxième zone annulaire (RB1, RB2) présentant de préférence un nombre de quatorze zones réfléchissantes (B1, B2, B7-B10, B15-B18, B23-B26 ; B3-B6, B11-B14, B19-B22, B27, B28).

11. Ensemble de lumière de pompage selon l'une des revendications précédentes, dans lequel la surface réfléchissante (10) comprend au moins une troisième zone annulaire (RB3) radialement intérieure qui est entourée par les première et deuxième zones annulaires (RB1, RB2) de la surface réfléchissante (10), la troisième zone annulaire (RB1) présentant de préférence un nombre de huit zones réfléchissantes (B29 à B36).

12. Ensemble de lumière de pompage selon la revendication 11, dans lequel l'ensemble de déviation (15) est conçu pour dévier le faisceau de lumière de pompage (8) au moins deux fois successivement entre chaque fois deux zones réfléchissantes (B30, B31 ; B32, B33 ; B34, B35) de la troisième zone annulaire (RB3).

13. Ensemble de lumière de pompage selon l'une des revendications précédentes, comprenant en outre : une source de lumière de pompage (7) pour générer le faisceau de lumière de pompage (8), une optique de collimation (9) pour collimater le faisceau de lumière de pompage (8) étant de préférence disposée dans le trajet de faisceau entre la source de lumière de pompage (7) et la surface réfléchissante (10).

14. Laser à disque (1), comprenant :
un ensemble de lumière de pompage (6) selon l'une des revendications précédentes ainsi qu'un milieu laser actif sous la forme d'un disque laser (2).

15. Procédé de pompage d'un milieu laser actif en forme de disque (2), consistant à :
focaliser plusieurs fois un faisceau de lumière de pompage (8) sur le milieu laser actif (2) à l'aide d'un moyen de focalisation (11), en particulier à l'aide d'un miroir concave, le faisceau de lumière de pompage (8) étant, entre des étapes de focalisation successives, dévié entre différentes zones réfléchissantes (B1 à B36) d'une surface réfléchissante (10) du moyen de focalisation (11), qui sont disposées dans différentes plages angulaires autour d'un axe central (12) de la surface réfléchissante (10) dans au moins une première zone annulaire (RB1) et une deuxième zone annulaire (RB2), le faisceau de lumière de pompage (8) étant dévié chaque fois au moins une fois entre deux zones réfléchissantes (B8, B9 ; B16, B17 ; B24, B25) de la première zone annulaire (RB1) ainsi qu'entre deux zones réfléchissantes (B4, B5 ; B12, B13 ; B20, B21) de la deuxième zone annulaire (RB2),
**caractérisé en ce**
**qu'**on effectue un nombre (N_{R}) de déviations entre deux zones réfléchissantes (B2 à B28) des deux zones annulaires (RB1, RB2) avec une inversion d'image du faisceau de lumière de pompage (8) dans la direction radiale par rapport à l'axe central (12) qui correspond à au moins un tiers, de préférence à au moins la moitié, du nombre total (N_{R} + N_{A}) de déviations entre deux zones réfléchissantes (B2 à B28) des deux zones annulaires (RB1, RB2).
